# EUROPÄISCHE PATENTSCHRIFT

(11) **EP 1 478 607 B1**
(45) Veröffentlichungstag und Bekanntmachung des Hinweises auf die Patenterteilung: **13.07.2005**
(21) Anmeldenummer: 03742946.1
(22) Anmeldetag: 19.02.2003
(51) Int. Cl.: C04B 41/88, C04B 41/91, C23C 18/18, H05K 3/38

(54) **VERFAHREN ZUR METALLISIERUNG VON KERAMIK AUF BASIS VON TITANATEN**
METHOD FOR METALLIZING TITANATE-BASED CERAMICS
PROCEDE DE METALLISATION DE CERAMIQUE A BASE DE TITANATES

(30) Priorität: 26.02.2002 DE 10208120
(43) Veröffentlichungstag der Anmeldung: 24.11.2004
(73) Patentinhaber: Dr.Ing. Max Schlötter GmbH & Co. KG, D-73312 Geislingen (DE)
(72) Erfinder: ROUBAL, Jiri, 73337 Bad Überkingen (DE)
(74) Vertreter: HOFFMANN - EITLE
(86) Internationale Anmeldenummer: PCT/EP2003/001681
(87) Internationale Veröffentlichungsnummer: WO 2003/072527

(56) Entgegenhaltungen:
- DE-A- 3 345 353
- US-A- 4 888 208

## Beschreibung

Die Erfindung betrifft ein Verfahren zum Metallisieren von Keramik auf Basis von Titanaten, wobei die Keramik in Schwefelsäure angeätzt wird.

Bei der nasschemischen Metallisierung von Keramikteilen wird gewöhnlich die nachfolgend beschriebene Behandlungsfolge angewendet:
1. Anätzen
2. Aktivieren
3. Stromlose Metallabscheidung, wobei eine leitfähige Oberfläche entsteht
4. Ggf. weitere Metallabscheidung, galvanisch oder stromlos je nach Bedarf

Um einen festen Verbund der Metallschicht mit dem Substrat zu erhalten, muss die Metallschicht in der Oberfläche des Grundmaterials verankert werden. Dies kommt dann zustande, wenn die Oberfläche eine bestimmte Rauhigkeit im Mikrobereich und eine kavernenartige Struktur aufweist.

Solche Strukturen sind in einigen Fällen bereits nach der Herstellung der Keramik-Substrate vorhanden, in anderen Fällen jedoch ist die Oberfläche der Substrate glatt, so dass der Behandlungsschritt "Anätzen" angewendet werden muss, damit haftende Überzüge abgeschieden werden können. Das Ätzmittel muss die Keramik inhomogen angreifen, damit die gewünschte Struktur mit zahlreichen Mikrokavernen entsteht. Ätzmittel, die das Grundmaterial gleichmäßig homogen abtragen, sind für die Vorbehandlung weniger geeignet, da keine Strukturen, wie oben beschrieben, durch die Einwirkung solcher Ätzmittel entstehen.

Keramik auf Basis von Titanaten, z.B. Bariumtitanat oder Titanate, die Elemente der seltenen Erden enthalten, wird für die Herstellung von Bauelementen verwendet und muss in bestimmten Anwendungsfällen für die Anwendung in der Elektronik metallisiert werden. Je nach Zusammensetzung und Herstellungsverfahren ist die Oberfläche der Keramikteile mehr oder weniger glatt. Die Keramikteile, die glatte Oberflächen aufweisen, müssen vor der Metallisierung angeätzt werden.

In der DE-OS 3 345 353 wird ein Verfahren beschrieben, in dem Keramik auf Basis von Aluminiumoxid, Bariumtitanat, Berylliumoxid in fluorwasserstoffsäurehaltigen Medien angeätzt wird. Im Beispiel 2 dieser Schrift wird eine Metallisierung von Bariumtitanat-Kondensatorkeramik beschrieben. Nach dem Anätzen in konzentrierter Fluorwasserstoffsäure wird eine Haftung von 5 N/mm erreicht. Aus ökologischen Gründen ist jedoch die Verwendung von Fluoriden unerwünscht. Zudem sind beim Umgang mit Fluorwasserstoffsäure und fluoridhaltigen Lösungen hohe Sicherheitsmaßnahmen einzuhalten.

In der DE-OS 3 523 957 wird ein Verfahren beschrieben, bei dem die Keramik in Alkalimetallhydroxidschmelzen oder in einer sauren Schmelze vorbehandelt wird, wobei ein Haftvermittler und/oder Sensibilisator und/oder Aktivator und/oder Katalysator dem Ätzmedium zugesetzt wird. Im Beispiel 5 dieser Schrift wird die Metallisierung von Bariumtitanat-Keramik beschrieben. Zur Aufrauhung wird eine Ammoniumhydrogensulfat-Schmelze verwendet, zu der Zinn(II)-Acetat zugesetzt wird. Die Keramikteile wurden bei 200 °C 10 Minuten behandelt. Nachteilig an diesem Verfahren ist jedoch, dass die Verwendung von Schmelzen einen hohen apparativen Aufwand erfordert. Die relativ hohen Arbeitstemperaturen sind zudem mit einem erhöhten Energieverbrauch verbunden und es besteht die Gefahr, dass die Keramik durch die thermische Belastung beschädigt wird.

In der DE-OS 3 737 757 wird ein Verfahren zur Metallisierung von Aluminiumoxid-Keramik beschrieben, bei dem konzentrierte Phosphorsäure bei 250 bis 360 °C zum Anätzen verwendet wird. Nachteilig ist jedoch auch hier die Anwendung der hohen Temperaturen, die zum einen einen hohen Energieaufwand zur Folge haben und zum anderen auch zu Beschädigungen der Keramik führen können.

In der DE-OS 3 833 441 wird ein Verfahren zur Metallisierung von Aluminiumoxid-Keramik beschrieben. Als Ätzmittel wird ein Phosphorsäure-Schwefelsäure-Gemisch bei 220 °C verwendet. Bei solch hohen Temperaturen besteht jedoch die Gefahr der Bildung von Säuredämpfen, die hochgradig ätzend sind und daher möglichst vermieden werden sollten. Darüber hinaus ist ein relativ hoher apparativer Aufwand aufgrund der hohen Temperaturen notwendig.

In der EP 0 254 201 A1 wird ein Ätzmittel auf Basis von anorganischen Säuren, wie Fluorwasserstoffsäure, Salzsäure, Phosphorsäure, Salpetersäure und anderen anorganischen Säuren vorgeschlagen. In dem Beispiel wird die Behandlung von Keramik in konzentrierter Phosphorsäure bei 175 °C und anschließend in einer Ammoniumbifluorid-Lösung beschrieben. Ein solches 2-stufiges Verfahren ist jedoch aus verfahrensökonomischen Gründen unvorteilhaft. Des weiteren sind Fluoridverbindungen aus ökologischen Gründen unverwünscht.

Die Aufgabe, die dieser Erfindung zugrunde liegt, besteht somit darin, ein Verfahren für die Metallisierung von Keramik zur Verfügung zu stellen, das die oben beschriebenen Nachteile nicht aufweist.

Die Aufgabe wird durch das Verfahren gemäß dem Patentanspruch 1 gelöst.

Vorteilhafte Ausführungsformen dieses Verfahrens sind in den weiteren Ansprüchen beschrieben.

Fig. 1 und 2 zeigen REM-Aufnahmen einer in Beispiel 1 hergestellten Oberfläche einer aus Titanaten der seltenen Erden bestehenden Keramik vor (Fig. 1) und nach (Fig. 2) dem erfindungsgemäßen Anätzen.

Fig. 3 und 4 stellen REM-Aufnahmen einer in Beispiel 13 hergestellten Oberfläche einer Keramik auf Basis von Bariumtitanat nach dem erfindungsgemäßen Anätzen bei unterschiedlichen Vergrößerungen dar. Im Vergleich dazu zeigt Fig. 5 die gleiche Oberfläche vor dem Anätzen.

Fig. 6 stellt eine REM-Aufnahme einer Keramik auf Basis von Barium-Samarium-Titanat nach dem Ätzen gemäß Beispiel 14 dieser Erfindung dar.

Bei der Anwendung des Verfahrens gemäß der vorliegenden Erfindung werden im Vergleich zu bisher bekannten Verfahren folgende Vorteile erzielt:
- gegenüber dem Stand der Technik werden niedrigere Temperaturen beim Anätzen angewendet
- die Verwendung von Fluorwasserstoffsäure oder Fluoriden entfällt
- die komplizierte Handhabung der Hydroxid- oder Salzschmelzen entfällt.

Das Verfahren betrifft Keramik auf Basis von Metalltitanaten, wobei als Metalle Erdalkalimetalle, z.B. Calcium und Barium, Elemente der seltenen Erden, wie z.B. Lanthan und Samarium, sowie andere Elemente in geringen Anteilen verwendet werden, um die gewünschten Eigenschaften der Keramikteile zu erreichen.

Es wurde nun gefunden, dass Schwefelsäurelösungen sich hervorragend zum Anätzen von Keramik auf Basis von Titanaten eignen. Dabei entstehen auf der Keramikoberfläche Strukturen, die eine hervorragende Haftung der nachfolgend abgeschiedenen Metallschichten ermöglichen.

Die Konzentration der Schwefelsäure beträgt 65 bis 90 Gew.%, vorzugsweise 70 bis 80 Gew.%.

Bei Konzentrationen unter 65 Gew.% wird die Keramik nur gering angegriffen, die Ergebnisse hinsichtlich der Haftung sind unbefriedigend. Um brauchbare Ergebnisse hinsichtlich der Haftung zu erreichen, wird Schwefelsäure in einer Konzentration von 65 bis 90 Gew.%, vorzugsweise 70 bis 80 Gew.% angewendet. Bei diesen Bedingungen wird die Keramik inhomogen abgetragen und es entstehen kavernenartige Strukturen im Mikrobereich, die eine feste Verankerung des nachfolgend abgeschiedenen Metallüberzuges ermöglichen. Höhere Konzentrationen als 90 Gew.% sind unvorteilhaft, da bereits bei Temperaturen um 130 °C starke Säurenebelbildung auftritt, was möglichst vermieden werden sollte. Darüber hinaus können mit konzentrierter Schwefelsäure keine kavernenartigen Mikrostrukturen erzielt werden, wodurch der nachfolgend aufgetragenen Metallüberzug eine nur geringe Haftung aufweist.

Die Arbeitstemperatur der Lösung während der Anätzungen beträgt 130 bis 170 °C, vorzugsweise 140 bis 160 °C. Als besonders vorteilhaft hat sich der Temperaturbereich zwischen 145 und 155 °C erwiesen. Vorzugsweise werden Temperatur und Konzentration so eingestellt, dass die Behandlungsdauer im Bereich von 5 bis 20 min liegt.

Bei Temperaturen niedriger als 130 °C erfolgt der Angriff auf die Keramikoberfläche zu langsam oder die Keramik wird nicht ausreichend angeätzt. Die Intensität der Anätzung steigt mit der angewendeten Temperatur. Temperaturen über 170 °C sind nicht bevorzugt, da dann die Säurenebelbildung relativ stark wird.

Die Obergrenze der angewendete Temperatur ist ferner durch den konzentrationsabhängigen Siedepunkt der Schwefelsäurelösung beschränkt, da oberhalb des Siedepunktes nicht gearbeitet werden sollte.

Aus umwelttechnischen Gründen sollte die Verdampfung von Schwefelsäure so niedrig wie möglich gehalten werden. Mit steigender Schwefelsäurekonzentration und steigender Temperatur erhöht sich der Anteil der Schwefelsäure in der Dampfphase. Die Verdunstung von Schwefelsäure ist mit der Bildung von weißem Säurenebel verbunden. Es ist daher vorteilhaft, die Konzentration und die Temperatur so zu wählen, dass die Bildung von Säuredämpfen minimal ist. Unter diesem Aspekt sollten bei höheren Konzentrationen die Temperaturen niedriger gewählt werden.

Nach dem Anätzen sind die Keramikteile gründlich mit Wasser zu spülen. Um lose Keramikpartikel von der Oberfläche zu entfernen, ist es vorteilhaft, die Spülung durch Ultraschall zu unterstützen. Um eine noch gründlichere Reinigung zu erzielen, können saure, alkalische oder neutrale Lösungen, die Tenside enthalten können, zum Reinigen der Keramikoberfläche nach dem Anätzen verwendet werden. Vorzugsweise kann die Reinigung ebenfalls durch eine Ultraschallbehandlung unterstützt werden.

Nach dem Spülen und ggf. einem zusätzlichen Reinigungsschritt wird die Keramikoberfläche aktiviert. Dazu können handelsübliche, bekannte Verfahren beispielsweise auf Basis von Palladiumverbindungen angewendet werden.

Nach der Aktivierung wird auf der Oberfläche der Keramik eine Metallschicht stromlos abgeschieden. Dazu werden stromlose Bäder, z.B. stromlose Nickel- oder Kupferbäder verwendet.

Diese Bäder enthalten Metallsalze, Komplexbildner, Stabilisatoren, Reduktionsmittel und andere Zusätze. Bei den auf dem Markt erhältlichen Nickelbädern werden Hypophosphit oder eine Borverbindung, wie z.B. Dimethylaminoboran, als Reduktionsmittel verwendet. Die auf dem Markt erhältlichen stromlosen Kupferbäder enthalten gewöhnlich Formaldehyd als Reduktionsmittel.

Nachdem die Keramikoberfläche in einem stromlosen Bad beschichtet wurde, können je nach Bedarf weitere Schichten stromlos oder galvanisch abgeschieden werden. Als Beispiele sind folgende Kombinationen zu nennen: Kupfer, Zinn oder Bleizinn; Kupfer, Nickel, Gold; Kupfer, Nickel. Die Metallschichten können mit Hilfe von bekannten Verfahren strukturiert werden, so dass Metallmuster auf der Keramikoberfläche entstehen.

Im folgenden wird die vorliegende Erfindung anhand von Beispielen näher erläutert.

### Beispiele

### Beispiel 1

Teile aus Keramik, die aus Titanaten der seltenen Erden bestehen, wurden in Schwefelsäure (74 Gew.%) bei 150 °C 10 Minuten lang behandelt, anschließend in Wasser gespült und getrocknet.

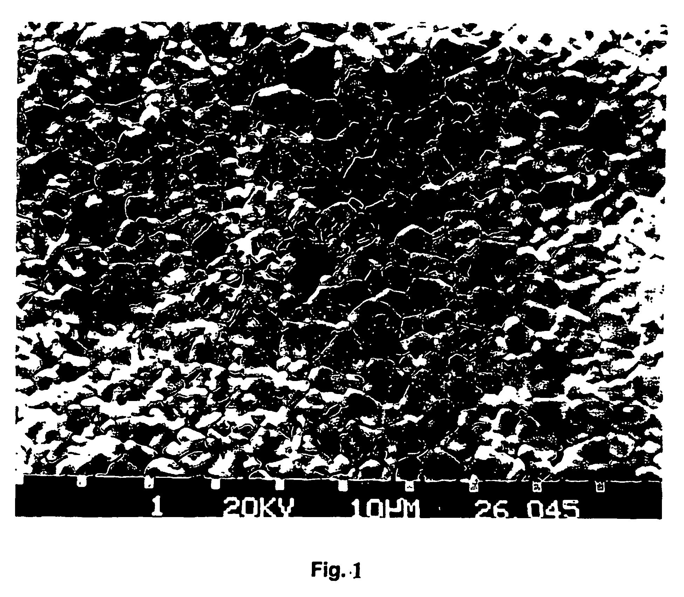

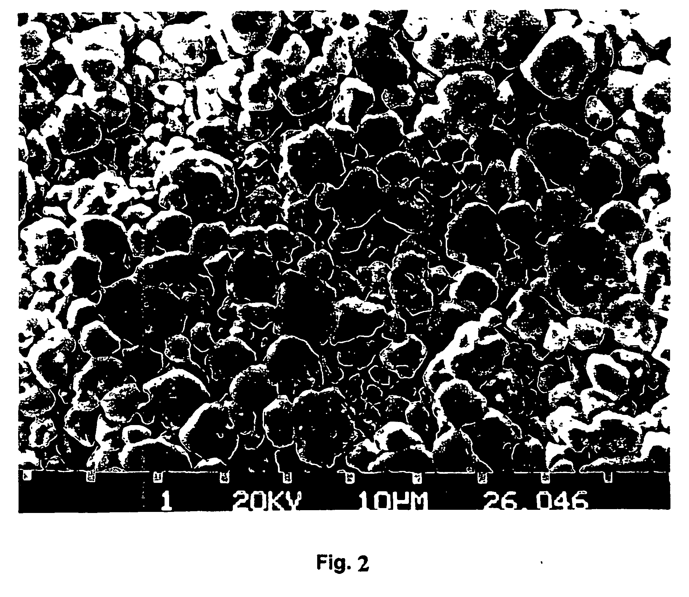

Die Wirkung der Ätzlösung wird in den REM-Aufnahmen (Fig. 1 und Fig. 2) deutlich. Figur 1 zeigt die Keramik vor dem Ätzen. Die Oberfläche ist verhältnismäßig glatt und die Korngrenzen sind eindeutig zu erkennen. Figur 2 zeigt die Oberfläche nach dem Ätzen. Im Vergleich zu Figur 1 wird festgestellt, dass die Keramik inhomogen und überwiegend an den Korngrenzen angegriffen wurde. Es entstanden Vertiefungen und Kavernen, die eine Verankerung des nachfolgend abgeschiedenen Metallniederschlages ermöglichen.

Nach dem Ätzen wurde die Keramik im handelsüblichen Aktivator auf Basis von Palladiumkolloid aktiviert und in einem chemischen Nickelbad, bei dem Dimethylaminoboran als Reduktionsmittel verwendet wurde, stromlos vernickelt. Auf dieser Leitschicht wurde Kupfer aus einem sauren Kupferbad galvanisch abgeschieden. Die Schichtdicke betrug 20 µm.

Beim Abschälen der Metallschicht (DIN 53494) wurde eine gute Haftung (6 N/cm) festgestellt.

### Beispiel 2 - 12

Keramikteile, gleicher Art wie im Beispiel 1 beschrieben, wurden in verschiedenen Schwefelsäurelösungen geätzt, wobei die Schwefelsäurekonzentration, die Temperatur und die Expositionszeit gemäß den Angaben in Tabelle 1 variiert wurden. Anschließend wurde die Haftung gemäß DIN 53494 beurteilt.

Die Ergebnisse sind in der folgenden Tabelle 1 aufgeführt.

**Tabelle 1:**

| Beispiel Nr. | Schwefelsäure-Konz. [Gew.%] | Temperatur [°C] | Behandlungs-Dauer [min] | Haftung [N/cm] |
|---|---|---|---|---|
| 1 | 74 | 150 | 10 | 6,0 |
| 2 | 69 | 150 | 20 | 10,0 |
| 3 | 74 | 130 | 60 | 8,0 |
| 4 | 74 | 130 | 180 | 11,5 |
| 5 | 74 | 140 | 20 | 5,9 |
| 6 | 74 | 140 | 30 | 12,8 |
| 7 | 74 | 150 | 20 | 13,5 |
| 8 | 74 | 160 | 5 | 4,0 |
| 9 | 74 | 160 | 10 | 15,5 |
| 10 | 80 | 140 | 20 | 5,5 |
| 11 | 87 | 150 | 20 | 5,2 |
| 12 | 87 | 150 | 60 | 6,3 |

### Beispiel 13

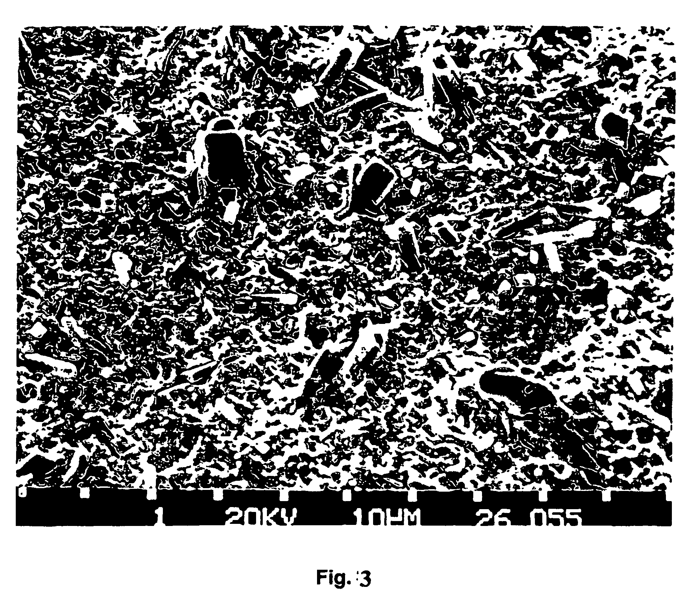

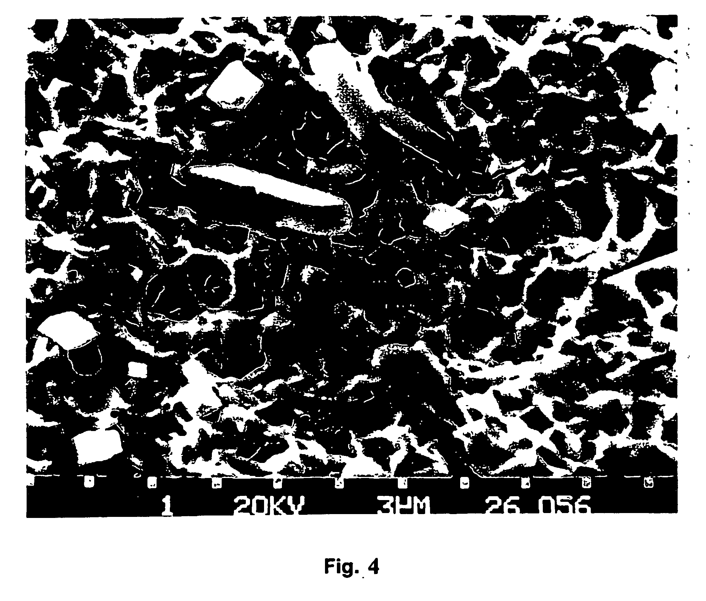

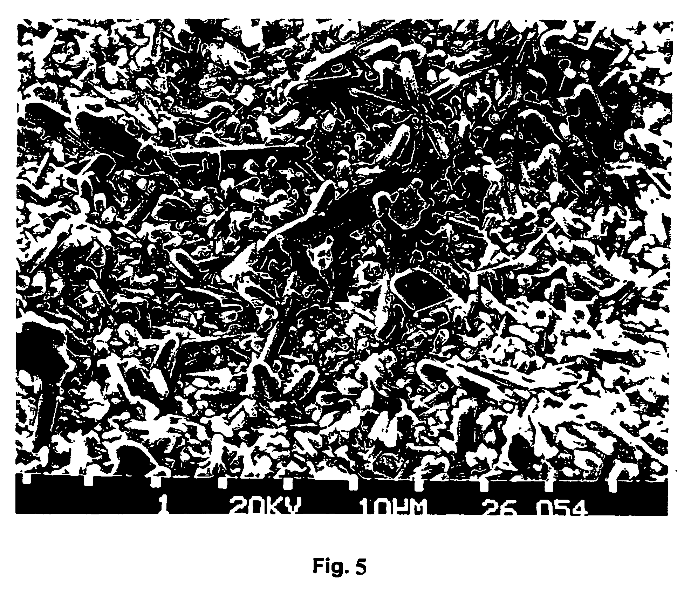

Plättchen aus Keramik auf Basis von Bariumtitanat wurden in 74 %iger Schwefelsäure bei 150 °C 30 Minuten lang behandelt. Die Fig. 3 und 4 stellen REM-Aufnahmen der Keramikoberfläche nach dem Ätzen bei verschiedenen Vergrößerungen dar. Zum Vergleich ist die Oberfläche vor dem Ätzen in Fig. 5 dargestellt. Wie in den REM-Aufnahmen deutlich zu erkennen ist, haben sich durch das Ätzen kavernenartige Vertiefungen auf der Oberfläche gebildet.

Keramikteile der gleichen Sorte wurden nach dem Ätzen in Wasser gespült, wobei die Spülung durch Ultraschall intensiviert wurde. Nach der Aktivierung, chemischen Vernickelung und galvanischen Verkupferung wie im Beispiel 1 beschrieben, wurde die Haftung quantitativ im Schältest (DIN 53494) ermittelt. Es wurden Werte zwischen 6 und 7 N/cm gemessen. Eine Erhöhung der Expositionszeit im Ätzbad auf 90 Minuten ergab Haftungswerte von 14 bis 16 N/cm.

### Beispiel 14

Ein Teil aus Keramik auf Basis von Barium-Samarium-Titanat wurde in 74 %iger Schwefelsäure bei 150 °C 30 Minuten lang geätzt. Nach dem Spülen und Aktivieren wie in Beispiel 13 wurde das Keramikteil in einem chemischen Kupferbad, in dem Formaldehyd als Reduktionsmittel verwendet wurde, metallisiert. Der Niederschlag wurde dann galvanisch im sauren Kupferbad verstärkt. Beim Schältest (DIN 53494) wurde eine Haftung von 10 N/cm ermittelt.

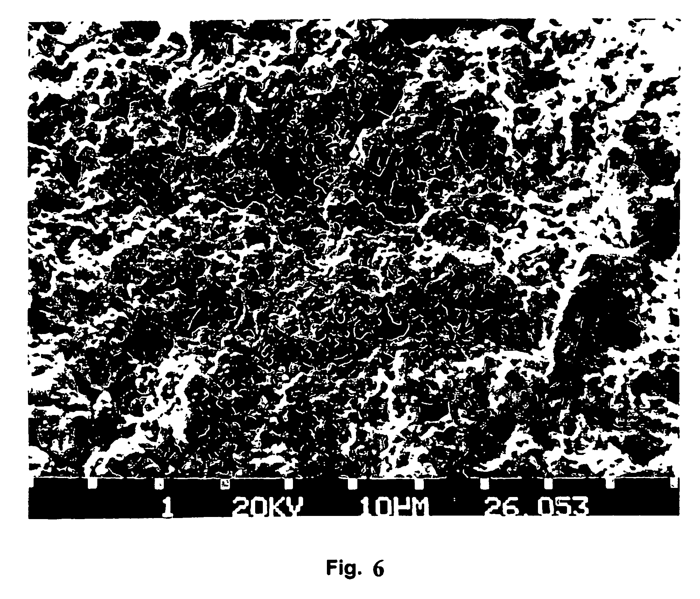

Dieser gute Wert für die Haftung ist im Einklang mit der Oberflächenstruktur, die durch das Ätzen erreicht wurde. Die REM-Aufnahme der Keramikoberfläche nach dem Ätzen ist in Fig. 6 dargestellt.

### Vergleichsbeispiele

Gleiche Keramikteile wie Beispiel 1 wurden in konzentrierter Schwefelsäure (96 Gew.%) bei 150°C unterschiedlich lang behandelt. Nach der Aktivierung, chemischen Vernickelung und galvanischen Verkupferung, die wie im Beispiel 1 ausgeführt wurden, wurde die Haftung gemäß DIN 53494 ermittelt.

| Behandlungsdauer [min] | Haftung [N/cm] |
|---|---|
| 20 | 0 |
| 60 | <2 |
| 90 | 2 |

Aus den Vergleichsbeispielen wird deutlich, dass die Keramikoberflächen, die mit konzentrierter Schwefelsäure angeätzt wurden, eine nur geringe Haftung aufweisen.

## Patentansprüche

1. Verfahren zur nasschemischen Metallisierung von Keramik auf Basis von Titanaten, umfassend die Schritte:
(a) Anätzen der Keramik, -
(b) Aktivieren der in Schritt (a) angeätzten Keramik
(c) Chemische Metallisierung der in Schritt (b) erhaltenen Keramik,
**dadurch gekennzeichnet, dass** in Schritt (a) eine Schwefelsäurelösung in einem Konzentrationsbereich von 65 bis 90 Gew.% bei einer Temperatur von 130 bis 170 °C zum Anätzen verwendet wird.

2. Verfahren gemäß Anspruch 1, **dadurch gekennzeichnet, dass** die Schwefelsäure im Konzentrationsbereich von 70 bis 80 Gew.% bei 140 bis 160 °C verwendet wird.

3. Verfahren gemäß einem der Ansprüche 1 oder 2, **dadurch gekennzeichnet, dass** die Keramik anschließend in einem Schritt (d) galvanisch oder chemisch metallisiert wird.

4. Verfahren gemäß einem oder mehreren der Ansprüche 1 bis 3, **dadurch gekennzeichnet, dass** die Keramik Bariumtitanat enthält.

5. Verfahren gemäß einem oder mehreren der Ansprüche 1 bis 4, **dadurch gekennzeichnet, dass** die Keramik Elemente der seltenen Erden enthält.

6. Verfahren gemäß einem oder mehreren der Ansprüche 1 bis 5, **dadurch gekennzeichnet, dass** die Keramik in Schritt (c) chemisch verkupfert wird.

7. Verfahren gemäß einem oder mehreren der Ansprüche 1 bis 5, **dadurch gekennzeichnet, dass** die Keramik in Schritt (c) chemisch vernickelt wird.

8. Verfahren gemäß einem oder mehreren der Ansprüche 1 bis 7, **dadurch gekennzeichnet, dass** die Keramik nach dem Anätzen vor Schritt (b) in einer neutralen Lösung und/oder alkalischen Lösung und/oder sauren Lösung gereinigt wird.

9. Verfahren gemäß Anspruch 8, **dadurch gekennzeichnet, dass** die Reinigung durch Ultraschall unterstützt wird.

## Claims

1. Process for wet-chemical metallisation of ceramic based on titanates, comprising the steps:
(a) etching of the ceramic,
(b) activation of the ceramic etched in step (a)
(c) chemical metallisation of the ceramic obtained in step (b)
**characterised in that** in step (a) a sulphuric acid solution in a concentration range from 65 to 90 wt.% at a temperature of 130 to 170°C is used for etching.

2. Process according to claim 1, **characterised in that** the sulphuric acid is used in the concentration range from 70 to 80 wt.% at 140 to 160°C.

3. Process according to one of claims 1 or 2, **characterised in that** the ceramic is then metallised galvanically or chemically in a step (d).

4. Process according to one or more of claims 1 to 3, **characterised in that** the ceramic contains barium titanate.

5. Process according to one or more of claims 1 to 4, **characterised in that** the ceramic contains elements of the rare earth metals.

6. Process according to one or more of claims 1 to 5, **characterised in that** the ceramic is copper-plated chemically in step (c).

7. Process according to one or more of claims 1 to 5, **characterised in that** the ceramic is nickel-plated chemically in step (c).

8. Process according to one or more of claims 1 to 7, **characterised in that** the ceramic is cleaned after etching before step (b) in a neutral solution and/or alkaline solution and/or acid solution.

9. Process according to claim 8, **characterised in that** cleaning is assisted by ultrasound.

## Revendications

1. Procédé de métallisation chimique par voie humide de céramique à base de titanates, comprenant les étapes suivantes :
(a) attaque chimique de la céramique,
(b) activation de la céramique attaquée chimiquement à l'étape (a),
(c) métallisation chimique de la céramique obtenue à l'étape (b)
**caractérisé en ce que**, à l'étape (a), on utilise une solution d'acide sulfurique dans une plage de concentrations de 65 à 90 % en poids, à une température de 130 à 170 °C pour effectuer l'attaque chimique.

2. Procédé selon la revendication 1, **caractérisé en ce que** l'acide sulfurique est utilisé en une plage de concentrations de 70 à 80 % en poids, à 140 à 160 °C.

3. Procédé selon l'une des revendications 1 ou 2, **caractérisé en ce que** la céramique est ensuite métallisée, par voie galvanique ou chimiquement, en une étape (d).

4. Procédé selon l'une ou plusieurs des revendications 1 à 3, **caractérisé en ce que** la céramique contient du titanate de baryum.

5. Procédé selon l'une ou plusieurs des revendications 1 à 4, **caractérisé en ce que** la céramique contient des éléments des terres rares.

6. Procédé selon l'une ou plusieurs des revendications 1 à 5, **caractérisé en ce que** la céramique est cuivrée chimiquement à l'étape (c).

7. Procédé selon l'une ou plusieurs des revendications 1 à 5, **caractérisé en ce que** la céramique est nickelée chimiquement à l'étape (c).

8. Procédé selon l'une ou plusieurs des revendications 1 à 7, **caractérisé en ce que**, après attaque chimique avant l'étape (b), la céramique est nettoyée dans une solution neutre et/ou une solution alcaline et/ou une solution acide.

9. Procédé selon la revendication 8, **caractérisé en ce que** le nettoyage est assisté par utilisation d'ultra-sons.
